# EUROPEAN PATENT APPLICATION

(11) **EP 1 717 850 A1**
(43) Date of publication of application: **02.11.2006**
(21) Application number: 05425278.8
(22) Date of filing: 29.04.2005
(51) Int. Cl.: H01L 21/336, H01L 29/78, H01L 29/40

(54) **Method of manufacturing a lateral power MOS transistor**

(71) Applicant: STMicroelectronics S.r.l., 20041 Agrate Brianza (Milano) (IT)
(72) Inventor: Moscatelli, Allesandro, 22100 Como (IT); Raffaglio, Claudia, 20146 Milano (IT)
(74) Representative: Botti, Mario

(57) **Abstract**

Process for manufacturing a screened lateral power MOS transistor (D) on a same semiconductor substrate, the process comprising the following steps of:
forming, on at least a first weakly doped drain portion (3), a protective layer (11) of a first type of material,
forming, on said whole lateral MOS transistor (D), a dielectric layer (12) of a second type of material being selectively etchable with respect to said first type of material,
forming, in a single step, in said dielectric layer (12):
a first opening (13) to expose at least one portion of a highly doped source portion (5),
a second opening (15) to expose at least one portion of a highly doped drain portion (6),
at least a third opening (14) to expose at least one portion of said protective layer (11),
filling in said first, second and said at least third opening (13,15 and 14) by means of a conductive layer so as to form respective drain and source contacts (16,17) electrically connected to the first and second highly doped portions (5,6), and one electrical screen (18) substantially aligned with said protective layer (11).

## Description

### Field of application

The present invention relates to a process for manufacturing power MOS lateral transistors.

More specifically, the invention relates to a process for manufacturing screened power MOS lateral transistors together with VLSI CMOS devices, on a same semiconductor substrate which comprises a semiconductive region of a first type of conductivity, the process comprising the following steps of:
- forming, on said semiconductive region, at least one lateral MOS transistor which comprises a gate electrode projecting from said semiconductive region and being insulated therefrom by means of an insulating layer, a source region comprising a first highly doped portion of a second type of conductivity aligned with said gate electrode and a realised drain region comprising a first weakly doped portion aligned with said gate electrode and a second highly doped portion included in said first weakly doped portion, both of the second type of conductivity.

The invention particularly, but not exclusively, relates to a process for manufacturing screened in VLSI CMOS technology and the following description is made with reference to this field of application by way of illustration only.

### Prior art

As it is well known, high efficiency power discrete MOSFET lateral transistors being integrated on a silicon semiconductor substrate are realised, for example, by means of MOSFET transistors of the Drain extension or LDMOSFET (lateral double diffused MOSFET) type.

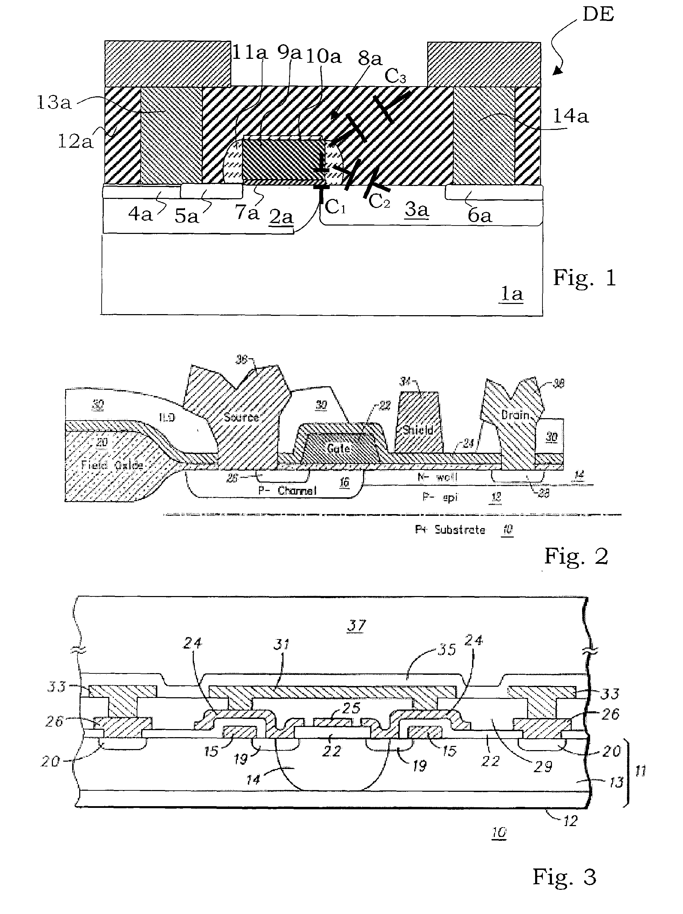

As it is shown in figure 1, a MOS transistor DE of the conventional extension Drain type with channel N integrated on a semiconductor substrate comprises a semiconductive region 1a of the P type, wherein a body region 2a of the P type is realised, which is more doped than a semiconductive region 1a adjacent to a drift region 3a of the N- type.

Inside the body region 2a, a first implanted region 4a of the P+ type being more doped than the adjacent body region 2a and a second implanted region 5a of the N+ type. In particular, such implanted regions 4a and 5a do not contact the drift region 3a and they realise the transistor D source region.

Inside the drift region 3a, a third implanted region 6a of the N+ type is realised. In particular, the third implanted region 6a does not contact the body region 2a and it realises, together with the drift region 3a, the transistor D drain region.

On the semiconductive region 1a, between the drift region 3a and the second region 5a, a gate electrode 8a is realised, which is insulated from the semiconductive region 1a by means of an oxide layer 7a.

The gate electrode 8a comprises a polysilicon layer 9a overlapped by a silicide layer 10a. Dielectric spacers 11 a are also provided on the side walls of the gate electrode 8a.

Once a premetal dielectric layer 12a has been formed on the whole device DE, contacts 13a and 14a are conventionally formed at the respective source and drain regions.

Recently, the need of reducing the feedback gate-drain Cgd capacity of such discrete LDMOSFET devices is felt, improving at the same time the reliability thanks to the reduction of the hot carriers phenomenon. Such feedback gate-drain Cgd capacity is generally made of three components C1 due to the capacity between the gate electrode and the drift region portion geometrically underneath the gate electrode, C2 due to the capacity between the gate electrode and the portion of the drift region lying outside the gate electrode, and C3 due to the capacity between the gate electrode and the drain metallic contact.

Moreover, it is known that the reduction of the MOSFET feedback capacity allows to increase the high frequency gain, to improve the amplification unilaterality and to decrease the signal distortion. This advantage is particularly important in the radiofrequency power amplifiers for wireless applications, where, often, RF LDMOSFET transistors are employed as amplification elements.

It is also known that a screening electrode, in general connected to the source region, suitably placed between the drain region and the gate electrode, reduces such feedback capacity, in particular its components C2 and C3. Its "field plate" effect, moreover, allows to reduce the electrical fields at the edge of the polysilicon layer forming the gate electrode towards the drain region, reducing the hot carriers phenomenon which could affect the component reliability.

A first solution to manufacture such a screening electrode in a MOSFET device of the discrete type, is described in the international application no. WO 0111681 to Spectrian Inc..

In such device, as shown in figure 2, after having realised the doped regions 14, 16, 25 and 28 in the substrate 10 and the gate electrode 22 in the substrate 10, a first dielectric layer 24 and a second dielectric layer 30 are deposited on the whole device. Thus, a first opening is realised in the second dielectric layer between the gate electrode and the drain region to realise the screen electrode 34. Subsequently, two openings are realised both in the first and in the second dielectric layer in correspondence with the source and drain terminals to realise the source and drain contacts 36, 38.

Although advantageous under several aspects, this solution is not compatible with the processes for realising the VLSI CMOS transistors. In fact, the formation of the dedicated dielectric layer 24 necessary to realise the screen 34, the realisation of the openings in sequence in the premetal dielectric layers and the use of layers of different matallisations for the screen on one side and contacts on the other, is expensive and not simple to be realised during the standard procedures of the VLSI CMOS devices, especially in case screened lateral MOSFET devices of reduced sizes are realised with VLSI technology. The presence of these additional technological steps could also introduce undesired electrical variations in the realised final VLSI CMOS devices.

A second solution, which provides to realise the screen metallisation by means of the metallisation layer forming the source metallisation, with subsequent simplification and saving of a mask with respect to the previous solution, is described in the US patent 6,44,117 to Motorola Inc..

In particular, as shown in figure 3, after having realised the source 19 and drain 20 regions and the sinker region 20 in the substrate 11 and the gate electrode 15 on such substrate 11, an intermetal dielectric layer 22 is deposited, wherein openings are realised on the source 19 and drain 20 regions. A metallic layer is formed on the device to form a metallic screen 24, the first drain contact 26 and a bus 25.

Although meeting the aim, even this solution is not exempt from drawbacks.

The efficiency of the screening and "field plate" effect of the metallic screen 24 however depends on the proximity of the same with respect to the drain region 20. A decrease of the thickness of the intermetal dielectric layer 22 to improve the screen efficiency would inevitably imply a capacity increase of the metallisation layer towards the gate electrode 15 with subsequent reduction of the device cut-off frequency. Then, in case one would like to use a similar approach in a VLSI CMOS platform where the premetal and intermetal dielectrics are perfectly planarized the screening effect of the metallisation layer would be lost due to the great distance of the metallic screen 24 from the substrate 11.

To overcome some of these drawbacks, it is proposed to realise a polysilicon screen as described in the US patents 6107160 and 6172400 to Spectrian Corporation.

However, in the VLSI CMOS platforms, or more in general for high performance MOSFET (high capacity in current and specific transconductance), due to the reduced gate oxide thickness, the polysilicon screen can introduce undesired effects of almost saturation due to the strong modulation of the drain drift region and it can be inefficient in reducing the electrical fields. In particular, for solving these drawbacks US patent 6172400 provides the use of more complex and expensive structures with thicker "bump oxide" below the screen gate electrode.

Moreover, by using this kind of polysilicon screen, which takes substantially "coplanar" conformation, it is necessary to consider the limits it imposes on the smaller device sizes which can be realised (and thus also on its series resistance), due to the simultaneous lithographic limits of width and separation between the two polysilicon layers forming respectively the gate electrode and the screen itself. Moreover, the complications should be considered which can derive from the self-aligned silicidification process of the active area layers, and i.e. of all the substrate portions which are not covered by a field oxide layer, which is frequently used in the platforms VLSI CMOS.

In fact, to obtain VLSI CMOS structures with high density and with high performance, the manufacturing processes of such devices are characterised by the following steps:
- formation of gate oxide layers having reduced thickness,
- reduced sizes of the device,
- self-aligned silicidification of polysilicon layers and active areas,
- planarization of the premetal and intermetal dielectric layers,
- "plug" (in general of tungsten) as contacts on the silicon and polysilicon and as path between the different metallisation layers.

However, such standard process steps are not easily compatible with the process steps to realise the previously described discrete power devices.

The technical problem underlying the present invention is that of devising a process for manufacturing MOSFET power devices together with VSLI CMOS devices, having such characteristics as to allow not to introduce process steps neither supplementary nor with modifications being particularly complex or expensive with respect to a standard VLSI CMOS process, overcoming the limits still limiting the processes realised according to the prior art.

### Summary of the invention

The solution idea underlying the present invention is that of realising a protection dielectric layer on the drift region of the MOSFET device, a second premetal dielectric layer on the whole device and forming, in a single step, some openings aligned with the source and drain regions until the substrate and an opening aligned with the drift region are exposed, the latter region exposing the protection dielectric layer.

On the basis of such solution idea the technical problem is solved by a process as previously indicated and defined by claim 1.

The characteristics and advantages of the device according to the invention will be apparent from the following description of an embodiment thereof given by way of indicative and non limiting example with reference to the annexed drawings.

### Brief description of the drawings

In such drawings:
figure 1 shows a section view of a first embodiment of a MOS transistor of the Drain extension type realised according to the prior art;
figure 2 shows a section view of a second embodiment of a MOS transistor of the Drain extension type realised according to the prior art;
figure 3 shows a section view of a third embodiment of a MOS transistor of the Drain extension type realised according to the prior art;
figure 4 shows a section view of a MOS transistor of the Drain extension type realised according to the invention.

### Detailed description

With reference to such figures, a process for manufacturing power MOS lateral transistors is described.

The process steps described hereafter do not form a complete process flow for manufacturing of integrated circuits. The present invention can be put into practice together with the techniques for manufacturing the integrated circuits currently used in the field, and only those commonly used process steps are included which are necessary for the comprehension of the present invention.

The figures showing perspective views of portions of an integrated circuit during the manufacturing are not drawn to scale, but they are instead drawn in such a way as to show the important characteristics of the invention.

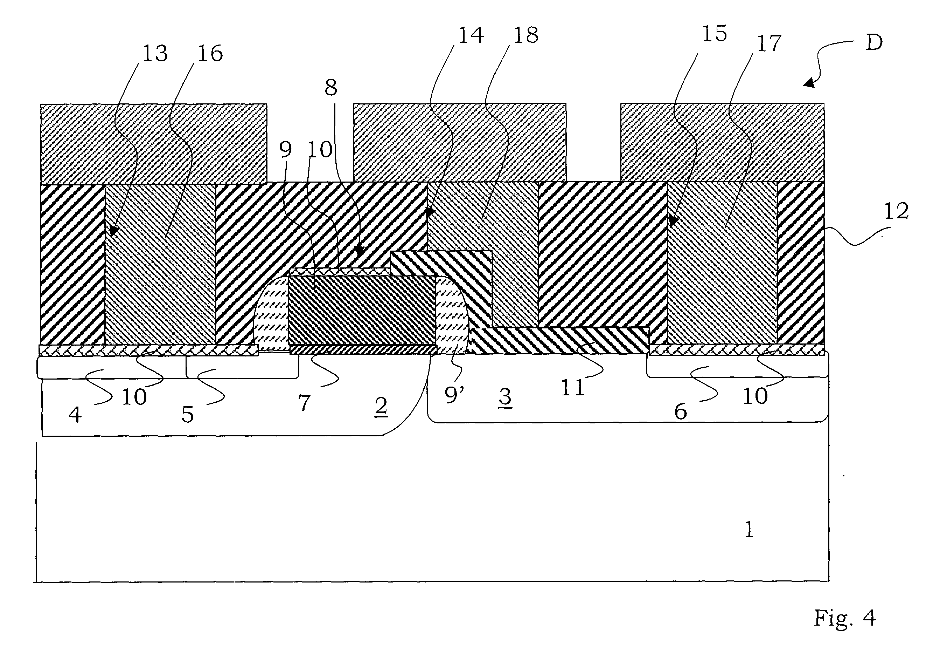

In particular, with reference to figure 4, a lateral MOS transistor D is described of the conventional Drain extension type with N channel integrated in a semiconductor substrate which comprises a semiconductive region 1 for example of the P type, wherein a body region 2 is realised being more doped than the semiconductive region 1 for example of the P type adjacent to a weakly doped drift region 3 for example of the N- type.

Inside the body region 2, a first implanted region 4 being more doped than an adjacent body region 2 for example of the P type and a second implanted highly doped region 5 for example of the N+ type are realised. In particular, these first and second implanted regions 4, 5 do not contact the drift region 3 and both of them realise the transistor D source region.

Inside the drift region 3, a third implanted highly doped region 6 for example of the N+ type is realised. In particular, the third implanted region 6 does not contact the body region 2 and it realises, together with the drift region 3, the transistor D drain region.

On the semiconductive region 1 between the drift region 3 and the second implanted region 5 the gate electrode 8 is realised, which comprises a polysilicon layer 9, and is insulated from the semiconductive region 1 by means of an insulating layer 7, for example of oxide. Advantageously, dielectric spacers 9' are provided on the side walls of the gate electrode 8.

According to the invention, a protection dielectric layer 11 is formed on the drift region 3 and advantageously on a portion of the gate electrode 8 on the side of such drift region 3.

Then a silicide layer 10 is realised on the transistor D portions left exposed from the dielectric layer 11. Therefore, it results that the regions 4, 5, 6 and an portion of the gate electrode 8 which is not covered by the protection dielectric layer 11 are overlapped by the silicide layer 10.

Advantageously, the protection dielectric layer 11 is made of an oxide layer, or of a nitride layer, or of a double oxide and nitride layer.

This protection dielectric layer 11 can advantageously be the same layer used in the standard VLSI CMOS platforms such as "silicide protection" to inhibit the self-aligned silicidification of active areas and conductive layers in the components requiring it.

In the case of a drain extension MOS or LDMOS transistor as the one just described in fact the drift region 3 has not to be silicidificated to sustain the applied high voltage, allowing the emptying of the carriers.

The greater the chosen thickness of the protection dielectric layer 11 is, the lower the screen effect and thus the benefit on the voltage seal and on the reduction of the feedback capacity is, but lower is the modulation of the drift region 3 is and thus the "on" resistance of the transistor D. Advantageously according to the invention, it is possible to find, according to the application, a thickness of the dielectric layer 11 which optimises the above cited electrical parameters. The choice of such thickness does not induce significant electrical variations on the other components integrated in the same technological platform, the protection dielectric layer 11 "silicide protection" being electrically non active. By way of indication, the thickness of the protection dielectric layer 11 can vary from 10 mm to 100 mm, whereas its lateral dimensions from 0,1 µm to 10 µm.

A premetal dielectric layer 12 is thus formed on the whole transistor D, which is possibly planarized by means of CMP (Chemical Mechanical Polishing).

Again according to the invention, at this point of the process, openings 13 and 15 are realised in the premetal dielectric layer 12 which respectively expose portions of the first, of the second 4, 5 and of the third 6 implanted region and simultaneously an opening 14 always in the premetal dielectric layer which exposes a portion of the protection dielectric layer 11. The openings 13, 15 are thus substantially aligned respectively with the second 5 and with the third 6 implanted region, whereas the opening 14 is substantially aligned with the drift region 3.

Advantageously, further openings can be realised in the premetal dielectric layer 12 being suitably spaced for the whole length of the drift region simultaneously with the openings 13, 14 and 15.

Such openings 13, 14 and 15 in the dielectric layer 12 and possible further openings realised in the dielectric layer 12 are thus filled in by a conductive layer, for example metallic, to respectively realise source and drain contacts 16 and 17 and an electric screen 18.

If more openings are realised in the premetal dielectric layer 12 along the drift region 3, the final electric screen 18 comprises more contacts which fill in these openings and are connected to each other in parallel, obtaining a greater screening effect.

Advantageously, the etching step which realises the openings 13, 14 and 15 in the dielectric layer 12 removes, in a selective way, the premetal dielectric layer, without damaging the protection dielectric layer 11.

This result can be advantageously realised both by calibrating in a suitable way the etching chemistry of the protection dielectric layer 11 and by suitably choosing the materials and thickness constituting this protection dielectric layer 11. In this way, the step of filling in the source and drain contacts 16 and 17, with one layer for example of tungsten, allows the normal contacting of the polysilicon and silicon terminals of the transistor D (gate polysilicon and silicon of the source and drain active areas), but it advantageously stops on the protection dielectric layer 11 forming the desired electric screen 18, which is then suitably connected to a first metallisation level.

Advantageously, for a greater efficiency of the electric screen 18, the opening 15 on the protective dielectric layer 11 is defined as stripe, i.e. with a different shape with respect to that of the contacts conventionally realised as plug with squared section.

In particular, the electric screen 18 on the protection dielectric layer 11 has the shape of a sufficiently narrow rectangle, for example < 1 µm, so as to maintain the pitch and thus the transistor D sizes reduced, but sufficiently long as to screen along the whole direction of the transistor D length "W", for example > 10 µm. At the same time, to maintain the compatibility with the CMOS VLSI devices, the openings 13 and 15 realised on active area and polysilicon, have reduced uniform sizes compatible with the technology used (in general squared with side lower than 0.5 µm).

Nothing forbids to realise the electric screen 18 on the dielectric layer 11 with the same sizes of the source and drain contacts 16 and 17.

Thus, the step of opening the contacts 16, 17 and 18 realised according to the invention exhibits a double uneveness relative to the premetal dielectric layer 12 and to the form factor of such openings which has never been realised, as in the present invention, in the process steps for manufacturing devices in a CMOS VLSI technology.

The process, according to the invention, also has the advantage of allowing to realise a screen 18 of reduced size and which can be reduced in step with the lithographic scaling, of being extremely efficient from the electrical point of view, as well as highly flexible from the viewpoint of the choice of the materials and of the relative thickness according to the application.

Moreover, in the case wherein the protection dielectric layer 11 covers part of the gate electrode 8, it is advantageously possible to realise the electric screen 18 substantially aligned or also partially overlapped to such gate electrode 8. Such embodiment not only allows to have a greater alignment tolerance between the various layers and elements composing the transistor D, but also to possibly obtain a screen 18 being closer to the gate electrode, particularly advantageous condition when a greater screening effect is to be obtained or when the sizes of the device and of the drift region 3 are particularly reduced (for example with low voltage components).

Thus, the position of the screen 18 (or of more contacts connected in parallel and forming the screen) on the drift region 3 and its position with respect to the gate electrode 8 can be advantageously determined according to the application and to the parameters which are to be optimised.

In conclusion, the process according to the invention is innovative both with respect to the realisation of the discrete power devices and with respect to the conventional devices realised in CMOS VLSI technologies. With these technologies in fact the contacts are opened, with conventional and thus fixed modes, always in regions the premetal dielectric layer is uniform with, exactly because the required sizes and tolerances, in general lower than 0.5 µm, need homogeneous and controlled etchings. In the process according to the invention instead the premetal dielectric layer 12 wherein the contacts are opened is not uniform since it is formed on the protection dielectric layer 11 which covers only one small portion of the device. Moreover, the contact 15 open on the protection dielectric layer 11, on the side of the transistor D drain region, advantageously has, as already said, a different form with respect to that used to contact active areas and polysilicon so as to fully perform the screening action. Such solutions implemented in the process according to the invention, although having never been adopted up to now in the realisation of VLSI CMOS devices as described, are however perfectly compatible with such technology.

## Claims

1. Process for manufacturing screened power MOS lateral transistors together with VLSI CMOS devices on a same semiconductor substrate which comprises a semiconductive region (1) of a first type of conductivity, the process comprising the following steps of:
forming, on said semiconductive region (1), at least one lateral MOS transistor (D) which comprises a gate electrode (8) projecting from said semiconductive region (1) and insulated from this one by means of an insulating layer (7), a source region comprising a first highly doped portion (5) of a second type of conductivity aligned with said gate electrode (8) and a realised drain region comprising a first weakly doped portion (3) aligned with said gate electrode (8) and a second highly doped portion (6) included in said first weakly doped portion (3), both of the second type of conductivity, the process **characterised in that** it comprises the following steps:
forming, on at least said first weakly doped portion (3), a protective layer (11) of a first type of maforming, on said whole lateral MOS transistor (D), a dielectric layer (12) of a second type of material being selectively etchable with respect to said first type of material,
forming, in a single step, in said dielectric layer (12):
a first opening (13) to expose at least one portion of said first highly doped portion (5),
a second opening (14) to expose at least one portion of said second highly doped portion (6),
at least a third opening (15) to expose at least one portion of said protective layer (11),
filling in said first, second and said at least third opening (13, 14 and 15) by means of a conductive layer so as to form respective drain and source contacts (16, 17) electrically connected respectively to said first and second highly doped portion (5, 6), and one electrical screen (18) substantially aligned with said protective layer (11).

2. Process according to claim 1, **characterised in that** said third opening (15) is realised with a different shape than that of said first and second openings (13, 14).

3. Process according to claim 2, **characterised in that** said third opening (15) is realised in a rectangular shape.

4. Process according to claim 1, **characterised in that** said protective layer (11) is made of a dielectric layer.

5. Process according to claim 4, **characterised in that** said protective layer (11) is made of an oxide layer or of a nitride layer.

6. Process according to claim 4, **characterised in that** said protective layer (11) is made of a double oxide and nitride layer.

7. Process according to claim 1, **characterised in that** a plurality of openings are open in said dielectric layer (12), simultaneously with said first, second and third opening (13, 14 and 15) to expose portions of said protective layer (11).

8. Process according to claim 1, **characterised in that** said protective layer (11) is made of a layer whose thickness varies within a range from 10 nm to 100 nm, whereas its lateral sizes are comprised in a range varying from 0.1 µm to 10 µm.

9. Process according to claim 1, **characterised in that** said protective layer (11) is also formed on a portion of said gate electrode (8).

10. Process according to claim 9, **characterised in that** said electric screen (18) is realised substantially aligned with said gate electrode (8) and insulated from this latter by means of said protective layer (11) which is formed on said portion of said gate electrode (8).

11. Process according to claim 9, **characterised in that** said electric screen (18) is realised partially overlapped to said gate electrode (8) and insulated from this latter by means of said protective layer (11) which is formed on said portion of said gate electrode (8).

12. Process according to claim 1 or 10 or 11, **characterised in that** a silicide layer is formed on portions of the transistor (D) not being covered by said protective layer (11).
